# EUROPÄISCHE PATENTSCHRIFT

(11) **EP 0 631 713 B1**
(45) Veröffentlichungstag und Bekanntmachung des Hinweises auf die Patenterteilung: **13.11.1996**
(21) Anmeldenummer: 93920519.1
(22) Anmeldetag: 17.03.1993
(51) Int. Cl.: H05K 3/34, B23K 1/00

(54) **VERFAHREN ZUM VERLÖTEN VON LEITERPLATTEN UNTER NIEDERDRUCK**
PROCESS FOR SOLDERING PRINTED CIRCUIT BOARDS UNDER LOW PRESSURE
PROCEDE POUR BRASER DES CARTES IMPRIMEES A BASSE PRESSION

(30) Priorität: 20.03.1992 DE 4209134; 31.07.1992 DE 4225378
(43) Veröffentlichungstag der Anmeldung: 04.01.1995
(73) Patentinhaber: Linde Aktiengesellschaft, 65189 Wiesbaden (DE)
(72) Erfinder: WANDKE, Ernst, D-8192 Geretsried (DE)
(74) Vertreter: Kasseckert, Rainer
(86) Internationale Anmeldenummer: EP9300624
(87) Internationale Veröffentlichungsnummer: WO9319575

(56) Entgegenhaltungen:
- EP-A- 0 517 430
- DE-A- 3 442 538
- DE-A- 4 032 328
- US-A- 4 577 398
- US-A- 4 921 157
- Derwent's abstract, no 86-80 808/12, Woche 8612, Zusammenfassung von SU 1 177 097, (AS BELO ELTRN INST), 1985-09-07

## Beschreibung

Die Erfindung betrifft ein Verfahren zum Verlöten von elektronischen Bauelementen mit Leiterplatten oder anderer durch Löten zu verbindender Elemente durch Wellenlöten sowie eine Lötanlage.

Der Einsatz von elektronischen Baueinheiten, die in Form von Leiterplatten mit einsteckbaren,aufsetzbaren oder oberflächenmontierbaren elektronischen Bauelementen (=Surface Mounted Devices = SMDs), die abschließend zu verlöten sind, gestaltet werden, erfährt einen ständigen Zuwachs. Zur Herstellung dieser Baueinheiten sind geeignet vorbereitete Leiterplatten mit den entsprechenden Bauelementen zu bestücken, diese sind in Vorbereitung auf den Lötvorgang gegebenfalls mit einem Klebstoff oder einer Lotpaste zu fixieren und schließlich sind die Leiterplatten und die Bauteile durch einen Lötvorgang fest und leitfähig miteinander zu verbinden. Dieser Lötvorgang wird heute zum einen in gängiger Weise mit Wellenlötanlagen ausgeführt, bei denen Lot durch eine oder mehrere, die Leiterplatten von unten berührenden Lotwellen auf entsprechende Bereiche aufgebracht wird und so die entsprechenden Teile verlötet werden. Zum anderen ist bei mit Lotpaste, Lot-preforms oder auch Lotdepots aufgebrachten Bauteilen lediglich ein Aufschmelzen des Lotanteils der Paste oder der Lot-preforms zu bewirken (Reflowlöten).

In beiden Fällen sind allerdings für eine gute Qualität der Lötverbindung Flußmittel anzuwenden. Entweder werden diese - im Falle der Wellenlötung - vor dem eigentlichen Lötvorgang aufgebracht, oder es enthält die angewendete Lotpaste oder Lot-preform sowohl Lot als auch Flußmittel. Die Flußmittel dienen dem Lötprozeß vor allem insofern, als sie die die Lötung beeinträchtigende Metalloxidschicht auf dem Werkstück zerstören sowie eine Oxidation der beteiligten Metalle beim Lötvorgang verhindern. Zudem wird die Oberflächenspannung des verflüssigten Lots vermindert. Flußmittel sind also multifunktional und dementsprechend aus einer Vielzahl von Substanzen zusammengesetzt. Nach dem Lötvorgang verbleiben jedoch Rückstände der Flußmittel auf den Leiterplatten, die zu nachteiligen Konsequenzen führen. Dazu gehören die Verringerung des Isolationswiderstandes zwischen auf der Leiterplatte befindlichen Leiterbahnen oder die vorschnelle Korrosion der Leiterbahnen. Deshalb sind die Flußmittelrückstände zu entfernen. Dies wird bekanntermaßen durch eine Reinigungsbehandlung der Platten mit FCKWs oder CKWs nach dem Lötvorgang erreicht. Die Anwendung der eben genannten und in bekannter Weise umweltschädigenden Stoffe - FCKW-Ozon-Problematik - soll jedoch heute minimiert oder gänzlich vermieden werden.

In einer neueren Vorgehensweise wird die Notwendigkeit von Flußmitteln dadurch zumindest herabgesetzt, daß der Verlötung der bestückten Platinen eine Vorbehandlung derselben mit einem Niederdruck-Plasma vorgeschaltet wird, wobei das Plasma aus einem Prozeßgas unter Mikrowellenanwendung und/oder Glimmentladung erzeugt wird (siehe DE-PS 39 36 955). Im Anschluß an diese Vorbehandlung wird der Lötvorgang jedoch wieder unter Normaldruck und unter Luft oder nur örtlich begrenzter Schutzgaszufuhr ausgeführt. Während des Verweilens zwischen Vorbehandlung und Lötung tritt hierbei also der Umstand ein, daß, da kein Sauerstoffabschluß vorhanden ist, erneut eine Oxidanlagerung und/oder Oxidbildung an den Lötstellen auftreten kann, wodurch das Lötergebnis negativ beeinflußt wird. Aus diesem Grund kann in der Regel mit diesem bekannten Verfahren nicht vollständig auf den Einsatz von Flußmitteln oder gleichwirkenden Hilfsstoffen verzichtet werden.

Aus der US-PS 5,192,582 ist darüber hinaus ein Verfahren zum flußmittelfreien Löten bekannt, bei dem Lot bereits vorab, also vor der Bestückung, auf betreffenden Flächen von Werkstücken plaziert wird, dort erkaltet und dabei eine oberflächliche Oxidschicht ausbildet. Im Anschluß an dieses Aufbringen von Lot erfolgt erst der eigentliche Lötprozeß, in dem dieses Lot die Verbindung zu einer Partnerfläche herstellen soll. Dabei ist für die Verlötung der zwei zu verbindenden Flächen das schon vorhandene Lot wiederzuverflüssigen (to reflow). Die US-PS 5,192,582 betrifft also insbesondere das Reflowlötprinzip, bei dem die Wiederverflüssigung schon vorhandenen Lots bekanntermaßen besondere Probleme bereitet. Als Problemlösung wird in der US-PS 5,192, 582 vorgeschlagen, vor und teilweise auch beim Reflowing ein Fluor enthaltendes Plasma auf die vorhandenen Lotperlen einwirken zu lassen, so die ansonsten von Flußmitteln attackierte Oxidschicht aufzubrechen und dann die beabsichtigte Lotverbindung entweder wieder bei Umgebungsdruck oder auch unter Plasmaeinwirkung herzustellen. Auch hier wird also zur Beförderung eines Lötprozesses ein Plasmavorbehandlung angewandt, das angesprochene Reflowlöten besitzt jedoch eine vom Wellenlöten abweichende Problemlage.

Die Aufgabenstellung der Erfindung besteht daher darin, ein Wellenlötverfahren zu finden, das die Verlötung von bestückten Leiterplatten flußmittelfrei, mit geringer Fehlerquote und qualitativ hochwertig ermöglicht.

Diese Aufgabe wird erfindungsgemäß dadurch gelöst, daß der Wellen-Lötvorgang eines Wellenlötprozesses unter Niederdruck und unter Plasmawirkung eines Prozeßgases durchgeführt wird.

Mit ausführungstechnischen Vorteilen werden vor- und nachgeschaltete Behandlungsschritte, wie beispielsweise der Anwärm- und Abkühlschritt, unter dem gleichem Niederdruck wie der Lötvorgang durchgeführt, wobei mit einem Niederdruck von unterhalb 100 mbar, vorzugsweise 0.5 bis 20 mbar, gearbeitet wird.

In einer vorteilhaften Variante wird beim Vorwärmschritt eine Vorbehandlung der durch Löten zu verbindenden Elemente durch eine dort erzeugte oder hineinreichende Plasmawirkung erreicht, wobei zur Atmosphärenbildung dort in der Regel das gleiche Prozeßgas wie zum Bilden der Lötatmosphäre herangezogen wird. Es kann jedoch in anderen Anwendungsfällen vorteilhaft sein, wenn die Atmosphäre beim Vorwärmschritt eine sich von der Lötatmosphäre unterscheidende Atmosphäre ist.

Mit besonderem Vorteil wird ein Prozeßgas derart gewählt, daß dieses zumindest als Plasma sowohl reduzierend wie oxidierend wirkt. Auf diese Weise werden sowohl Oxide als auch andere Verunreinigungen, z.B. fettige oder ölige Rückstände, in der Behandlung vom Werkstück wirksam entfernt bzw. ferngehalten.

Als besonders geeignet werden erfindungsgemäß Gemische angewandt, die aus

| | |
|---|---|
| 0.5 bis 10 Vol% | Sauerstoff |
| 80 bis 20 Vol% | Wasserstoff |
| 20 bis 80 Vol% | CF₄, N₂ oder Ar |

bestehen.

Wie im Prinzip bekannt, wird auch erfindungsgemäß mit Vorteil das Plasma aus dem jeweiligen Prozeßgasgemisch bei den vorgeschriebenen Niederdruckbedingungen durch die Einwirkung von Mikrowellen, Hochfrequenzwellen oder/und einer Glimmentladung erzeugt.

In einer besonders vorteilhaften Ausgestaltung der Erfindung wird eine Plasmabildung in der unmittelbaren Umgebung des Lötvorgangs, also bei der Lötstelle, durchgeführt, so daß insbesondere die Lötung in einer intensiven Plasma-Atmosphäre stattfinden. Diese Maßnahme führt zu weitergehenden, qualitativen Vorteilen. Eine besonders günstige Realisierung dieser Variante der Erfindung besteht darin, daß das Lotbad mit Lotwellen als Kathode einer Glimmentladung geschaltet und so unmittelbar dort die Plasmabildung bewirkt wird.

In einer Mehrzahl von Fällen besteht bei der Plasmaerzeugung an der Lötstelle sogar die Möglichkeit, eine weitere, eigenständige Plasmaerzeugung an anderer Stelle entfallen zu lassen, da die Wirksamkeit des an der Lötstelle erzeugten Plasmas auch in den vor der Lötstelle liegenden Lötanlagenbereich hineinreicht und bereits so eine ausreichende Lötvorbereitung erzielt wird.

Weitere, vorteilhafte Ausgestaltungen der Erfindung sind den weiteren Unteransprüchen zu entnehmen.

Eine erfindungsgemäße Lötanlage ist dadurch gekennzeichnet, daß eine die Lötstation und weitere Stationen umfassende, gegen die Umgebung gasdichte Anlagenkammer (6) vorhanden ist, und daß Mittel vorgesehen sind, um in dieser Kammmer einen Niederdruck zu erzeugen, und daß Einrichtungen (21,23, 34) gegeben sind um dort wo die Lotwellen erzeugt werden, eine Niederdruck-Atmosphäre im Plasmazustand zu bilden.

Bei unterschiedlichen Gasatmosphären in den verschiedenen Anlagenbereichen sind mit Vorteil gasströmungshemmende Einbauten zwischen einzelnen Stationen, insbesondere gegebenenfalls zwischen Vorwärmzone und Lötzone, vorgesehen.

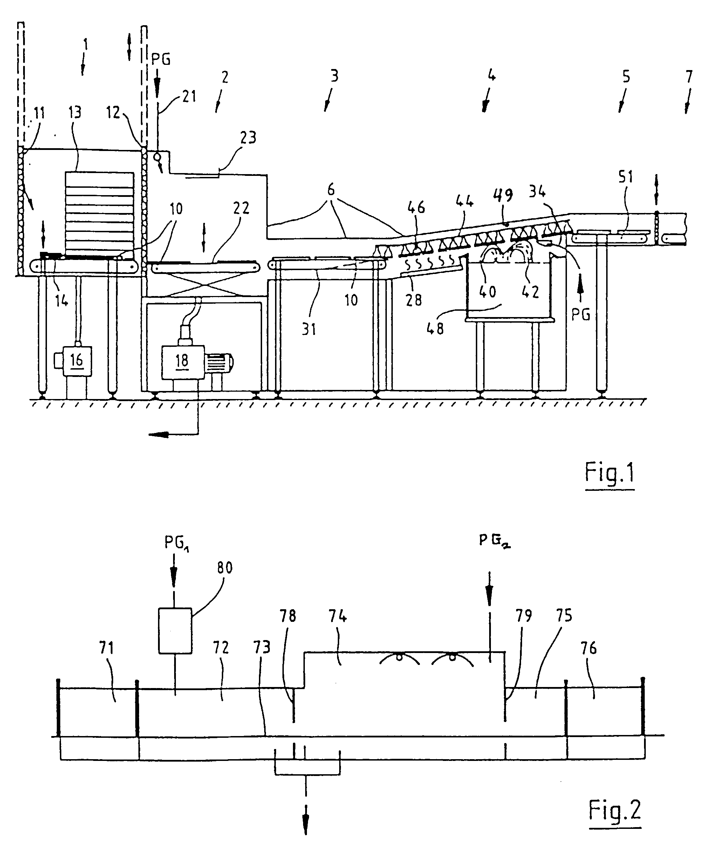

Unter Bezugnahme auf die Figur 1 wird die Erfindung im folgenden beispielhaft näher beschrieben. Es zeigt:
- Figur 1: eine Wellenlötanlage gemäß der Erfindung in Seitenansicht im Schnitt - schematisch;
- Figur 2: eine Reflowlötanlage gemäß Stand der Technik - ebenfalls im Schnitt - mit übertragbaren Ausgestaltungsdetails.
In der Figur 1 handelt es sich um eine Wellenlöt-Lötanlage, die eine Eintrittsschleuse 1, eine Anlagenkammer 6 mit Eintritts- bzw. Vorbehandlungsstation 2, Übergabestation 3, Wellenlötstation 4 und Auslaufkanal 5 sowie eine Austrittsschleuse 7 aufweist.

Der Betriebsablauf der gezeigten Anlage ist derart, daß zu Beginn eine mit Leiterplatten 10 gefüllte Stapeleinheit 13 in die Eintrittsschleuse 1 eingeführt wird. Dazu ist der Schleusenschieber 11 zunächst geöffnet und die Eintrittsschleusenkammer somit unter Umgebungsdruck. Mittels einer schaltbaren Pumpe 16 wird nach Verschließen des Schleusenschiebers 11 die Luft aus der Eintrittsschleuse 1 abgepumpt. Nach geeigneter Zeit, d.h., wenn die Luft weitgehend aus der Schleusenkammer entfernt ist, wird diese mit Prozeßgas oder auch einem Inertgas,z.B. Stickstoff, gespült. Dieser Abpumpund Kühlzyklus kann gegebenenfalls aus Gründen der Atmosphärenreinheit mehrfach ausgeführt werden. Schließlich folgt ein Abpumpen, das so lange durchgeführt wird, bis ein Druckniveau in der Schleuse 1 hergestellt ist, wie es auch in der Anlagenkammer 6 der Lötanlage, also in der Eintritts- bzw. Vorbehandlungsstation 2, der Übergabestation 3 und der Lötstation 4 mit Auslaufkanal 5,besteht.Im vorliegenden Beispielfall wird dort ein Druckniveau von etwa 1 bis 2 mbar mit Hilfe einer weiteren,unter der Anlagenkammer 6 angeordneten Hauptpumpe 18 einerseits und geeigneter Prozeßgaszufuhr andererseits eingehalten. Dieser Druck ist letzlich also auch in der Eintrittsschleuse 1 herzustellen.

Ist die Druckangleichung Schleuse 1 - Anlagenkammer 6 vollständig vollzogen, wird der innere Schleusenschieber 12 geöffnet und die Leiterplatten 10 einzeln aus der Stapeleinheit 13 in die Vorbehandlungsstation 2 überführt. Dazu dient eine in der Schleuse 1 angeordnete Ausschubeinrichtung 14, die die Leiterplatten aus den Fächern der Stapeleinheit herausbefördert und diese auf ein in Höhe und Laufgeschwindigkeit jeweils geeignet eingestelltes Förderband 22 transportiert. Eine erste Prozeßgaszufuhr in die Anlagenkammer 6 erfolgt über einen Düsenstock 21, der nach dem inneren Schleusenschieber 12 oben in der Anlagenkammer angeordnet ist. Mit diesem wird Prozeßgas PG in geeigneter Menge - diese ist im wesentlichen abhängig von der eingestellten Pumpleistung der Hauptpumpe 18 sowie vom angestrebten Aniagendruck - in die Lötanlage eingeführt (bei der gezeigten Anlage sind insgesamt etwa 0.2 bis 0.5 Nm³/h, im allgemeinen im Regelfall zwischen 0.1 und 2 Nm³ zuzuführen). Benachbart zum Düsenstock 21 ist in der Eintritts- bzw. Vorbehandlungsstation 2 ein Mikrowellensender 23 angeordnet. Der Mikrowellensender 23 dient zur Erzeugung des Plasmas aus dem Prozeßgas, d.h. der Herstellung eines reaktiven, Radikale und Ionen enthaltenden Gasgemisches aus diesem. Dazu erfolgt eine Mikrowellenanregung mit 100 bis 1000 Watt und mit einer Frequenz von ca. 2.5 GHz. Auf diese Weise wird in der Vorbehandlungsstation aus einem Prozeßgas, das mit Vorteil aus

| | |
|---|---|
| 2 bis 8 Vol% | Sauerstoff, |
| 40 bis 60 Vol% | Wasserstoff und |
| 30 bis 55 Vol% | Tetrafluorkohlenstoff (CF₄) |

besteht, ein effektives Plasma erzeugt. Dieses, aus der eben genannten Gasmischung erhaltene Plasma wirkt sowohl oxidierend wie auch reduzierend und führt dazu, daß - nach ausreichender Einwirkzeit - von den zu behandelten Leiterplatten fettige und ölige Stoffe ebenso, wie auch die immer vorhandene, den Lötprozeß störende Metalloxidschicht bereits nach Anlageneintritt entfernt werden. Hierzu ist im Regelfall eine Verweildauer der Leiterplatten im Wirkbereich des Plasmas von 0.5 bis 3 Minuten notwendig. Diese Einwirkzeit wird bei der gezeigten Anlage durch die stattfindenden Tranportabläufe in der Eintritts- bzw. Vorbehandlungszone 2 ohne weiteres eingehalten.

Im Hinblick auf die gezeigte Anlage ist zudem darauf hinzuweisen, daß die Leiterplatten 10 auch nach Verlassen der Vorbehandlungssation 2 und dem Übertritt in die Übergabestation 3 mit dem Förderband 31 den Wirkbereich des Plasmas nicht gänzlich verlassen, sondern auch im Bereich 3 noch einer Wirkung des in der Vorbehandlungstation 3 erzeugten Plasmas ausgesetzt sind. Gerade erfindungsgemäß und im Gegensatz zu bekannten Verfahren bleiben ja die Leiterplatten unter Niederdruck und Prozeßgas bzw. teilweise Plasmagas und werden nicht wieder höheren Drücken und gegebenenfalls unreinen Atmosphären ausgesetzt. Eine erneute Sauerstoffanlagerung und/oder Oxidation wird also grundsätzlich vermieden und der günstige Vorbereitungszustand der Teile für die Verlötung aufrechterhalten.

Am Ende der Übergabestation 3 werden die Leiterplatten einer frei hängend fördernden Transporteinrichtung 44 mit Tragelementen 46 übergeben. Das Förderband 31 und die Transporteinrichtung 44 sind dazu hinsichtlich der Fördergeschwindigkeit synchronisiert. Die Tansporteinrichtung 44 befördert nun die Leiterplatten 10 mit einem geeignetem Steigungswinkel zu den beiden Lotwellen 40 und 42 (Doppelwellenlöten!) und über diese hinweg, wobei vorausliegend eine aus Infrarotstrahlern bestehende Vorwärmeinrichtung 28 überfahren wird. Durch die beiden Lotwellen 40 und 42 erfolgt die Verlötung, wobei mit Antihaftmittel vorbehandelte Bereiche der Leiterplatten vom Lot unberührt bleiben. Beim Lötvorgang selbst bewirken die Niederdruckbedingungen und die Prozeßgasatmosphäre ein leichtfließendes und feinbenetzendes Lot, welches keines Flußmittelzusatzes bedarf. Dabei ist mit Vorteil eine weitere Prozeßgaszufuhr 34 benachbart zu den Lotwellen 40,42 angeordnet.

In einer besonders vorteilhaften Variante der Erfindung kann das Lotbad 48 mit den beiden Lotwellen 40 und 42 als Kathode gegenüber einer oberhalb der Transporteineinrichtung 44 angeordneten Anode 49 gepolt und so unmittelbar über dem Lotbad und den Lotwellen eine Glimmentladungs-Plasmabildung bewirkt werden, die eine besondere Aktivierung und zusätzliche vorteilhafte Auswirkung auf den Lötprozeß zur Folge hat. Auf diese Weise werden äußerst hochwertige Lötverbindungen und besonders niedrige Fehlerraten erzielt. In einer alternativen Ausgestaltung kann bei dieser Erfindungsvariante die Plasmabildung bei den Lotwellen ebenso durch einen dort geeignet plazierten Mikrowellen- oder HF-Sender erreicht werden.

In vielen Fällen, z.B. in der Regel bei nicht über Normalmaß verunreinigten und/oder oxidierten Leiterplatten, kann diese Ausgestaltung der Erfindung sogar ohne eine eigenständige Plasmabildung in der Eintrittsstation 2 betrieben werden, da das bei den Lotwellen erzeugte Plasma bereits für eine genügende Vorbereitung der Leiterplatten bei deren Zulauf zu den Lotwellen sorgt und andererseits die Plasmawirkung beim Lötvorgang selbst unverändert erhalten bleibt. Hier und allgemein gilt, daß das Plasma in seiner Wirkung nicht nur auf den unmittelbaren Bereich seiner Erzeugung beschränkt ist.

Nach dem Durchlaufen der Lötstation 4 treten die jetzt verlöteten Leiterplatten in den Auslaufkanal 5 der Lötanlage ein. Dieser ist mit einer Fördereinrichtung 51 derart versehen, daß die Leiterplatten aus der Lötstation 4 übernommen und weiterbefördert werden. Der Auslaufkanal 5 führt zu einer Austrittschleuse 7 mit zugehörigen Schiebern. Diese Schleuse wird durch die Födereinrichtung 51 in der Weise beschickt, daß sobald beispielsweise zwei Leiterplatten von der Fördereinrichtung 44 übernommen sind, diese bis zum Eintreffen der nächsten Platte mit einem schnellen Vorschub in die Austrittsschleuse 7 überführt werden, so daß die Zeit für den in der Schleuse auszuführenden Ausschleußprozeß gewonnen wird. Für den Ausschleußprozeß wird die Schleuse 7 entweder mit Luft oder beispielsweise auch Stickstoff bis auf Umgebungsdruck gespült und dann der Auslaßschieber geöffnet. Nach dem Ausfahren aus der Schleuse 7 sind die Leiterplatten vollständig fertig behandelt, da aufgrund der flußmittelfreien Verfahrensweise die sonst übliche Nachreinigung entfallen kann. Die Schleuse 7 ist selbstverständlich für den nächsten Schleußprozeß wieder zu evakuieren.

Auf diese Weise, also mit der Durchführung aller wesentlichen Verfahrensschritte einer Verlötung unter Niederdruck und in einer Plasma- bzw.Prozeßgasatmosphäre, wird ein neuartiges Lötverfahren zur Verfügung gestellt,das unter Verzicht auf Flußmittel und folglich auch ohne FCKW-freisetzende Nachreinigungsbehanlungen qualitativ hochwertige, in umweltschonender Weise hergestellte Lötungen, insbesondere fertig verlötete Leiterplatten, liefert.

Die Figur 2 zeigt nun eine Durchlauf-Reflow-Lötanlage gemäß dem Stand der Technik wobei hier Details auf die Erfindung übertragbar sind und wobei die Leiterplatten nacheinander auf einer Transporteinrichtung 73 angeordnet durch die Anlage befördert werden (Leiterplatten sind in Figur 2 nicht eingezeichnet).

Die Anlage weist eine Eintrittsschleuse 71, einen Vorwärmund gegfs.Vorbehandlungsbereich 72, eine Lötstation 74 und eine Austrittsschleuse 76 auf. Die Druckerniedrigung in den relevanten Anlagenbereichen, also dem Vorwärmbereich 72, der Lötstation 74 sowie einer kurzen Auslaufzone 75 (zusammen entspricht dies der Anlagenkammer), wird durch eine nicht gezeigte Pumpanlage bewerkstelligt. Durch die Eintrittsschleuse 71 werden die zu bearbeitenden Leiterplatten einzeln oder in kleinen Gruppen in die Anlage eingeführt, wobei die Schleusung entsprechend der oben beschriebenen Stapelschleusung ausgeführt wird und dies auch problemlos in der zur Verfügung stehenden Taktzeit möglich ist (minimal ca. 10 sec bis 20 sec). Zur Beförderung der Leiterplatten wird dazu taktpassend ein schrittweiser Vorschub mit der Transporteinrichtung 73 ausgeführt, wodurch die Leiterplatten von einer Station zur nächsten weiterbefördert und letzlich durch die gesamte Anlage transportiert werden.

Von der Eintrittsschleuse 71 treten die Leiterplatten dabei zunächst in die Vorwärm- und Vorbehandlungsstation 72 über. Dort erfolgt die Zufuhr und erste Einwirkung von Plasmagas.

Im gezeigten Fall wird das Plasma aus dem Prozeßgas PG₁ in einer externen Plasmaerzeugungseinrichtung 80 gebildet und dann der Vorwärm- und Vorbehandlungsstation 72 zugeführt. Als Prozeßgas kommt beispielsweise ein aus 5 % Sauerstoff, 60 % Wasserstoff und 35 % Tetrafluorkohlenstoff (CF₄) bestehendes Gasgemisch zum Einsatz. Zudem erfolgt im Bereich 72 mittels entsprechender Heizeinrichtungen die Vorerwärmung der Leiterplatten auf ca. 150 °C. Der Transport durch und die Behandlung in dieser Zone dauert etwa zwischen 20 und 240 sec. Im Anschluß daran laufen die Leiterplatten in die Lötzone 74 ein. Sowohl Vorbehandlungs- als auch Lötzone stehen dabei auf einem Druckniveau unterhalb 5 mbar. Im vorliegenden Fall wird der Lötzone jedoch kein weiteres Prozeßgasgemisch wie eben beschrieben zugeführt, sondern ein Stickstoff anstelle von CF4 enthaltendes Gasgemisch PG2,da nach dem hochwirksamen Prozeßgas aus dem Vorraum 72 ein Inertgas enthaltendes Lötprozeßgas ausreichend ist, wobei die Plasmabildung hier wiederum außerhalb erfolgt. Durch an der Decke der Lötzone 74 angeordnete Heizstrahler wird schließlich in der Lötzone 74 die Verlötung ausgelöst (T ca.210 °C). D.h., daß beispielsweise in Form von Lotdepots aufgebrachtes Lot, also geeignet portionierte und positionierte Lotmengen auf der Leiterplatte, erschmolzen werden und so die Verlötung der jeweiligen Teile bewirkt wird. Die Lötstation ist bei der gezeigten Anlage durch Trennwände 78, 79 zwar nicht gasdicht aber doch gasströmungshemmend von der Vorbehandlungskammer 72 und dem anschließenden Anlagenbereich 75 abgetrennt. Auf diese Weise können die unterschiedliche Atmosphären in den verschiedenen Anlagenbereichen besser aufrechterhalten werden.

Bereits im Anlagenbereich 75 beginnt die Abkühlung der Leiterplatten nach dem Reflowvorgang in der Lötstation 74, wobei dieser Anlagenbereich z.B. unter Stickstoffzufuhr stehen kann. Aus dem Bereich 75 treten die Leiterplatten schließlich in die Austrittschleuse 76 über, wo sie z.B. wiederum unter Stickstoff vollständig abgekühlt und auf Normaldruck gebracht werden. Damit ist die Verlötung der Leiterplatten abgeschlossen, wobei für den gesamten Lötvorgang wiederum bevorzugt Lot ohne Flußmittel oder nur geringst mögliche Flußmittelanteile zur Anwendung kommt. Diese Verfahrensvariante gemäß Figur 2 kann außerdem ebenso - etwas vereinfacht aber in der Regel ausreichend wirksam - ohne Trennwände und ohne Plasmazufuhr zum Vorwärmbereich 72 ausgeführt werden, wobei der Vorwärmbereich dann seine Atmosphäre aus der Lötzone 74 erhält.

## Patentansprüche

1. Verfahren zum Verlöten von elektronischen Bauelementen mit Leiterplatten gemäß einem Wellenlötprozeß,
bei dem die Leiterplatten über eine oder mehrere, aus Flüssiglot gebildete, Lotwelle oder Lotwellen hinweg transportiert werden, wobei der Lötvorgang selbst bei der Lotwelle oder den Lotwellen stattfindet,
und bei dem gegebenenfalls diesem Lötvorgang vor- und nachgeschaltete Schritte, beispielsweise ein Vorwärmschritt und/oder ein Abkühlschritt, durchgeführt werden,
dadurch gekennzeichnet,
daß zumindest der Lötvorgang selbst unter Niederdruck und unter Plasmawirkung eines Prozeßgases durchgeführt wird.

2. Verfahren nach Anspruch 1, dadurch gekennzeichnet, daß dem Lötvorgang Schritte vor- oder nachgeschaltet werden, die unter dem gleichen Niederdruck durchgeführt werden wie der Lötvorgang selbst.

3. Verfahren nach Anspruch 1 oder 2, dadurch gekennzeichnet, daß bei einem Niederdruck von unterhalb 100 mbar, vorzugsweise zwischen 0,5 und 20 mbar, gearbeitet wird.

4. Verfahren nach einem der Ansprüche 1 bis 3, dadurch gekennzeichnet, daß ein Vorwärmschritt erfolgt und beim Vorwärmen eine Vorbehandlung der durch Löten zu verbindenden Elemente durch eine dort erzeugte oder eine dort hineinreichende Plasmawirkung erreicht wird,
wobei zur Plasma-Atmosphärenbildung dort das gleiche Prozeßgas wie zum Bilden der Lötatmosphäre herangezogen wird.

5. Verfahren nach Anspruch 4, dadurch gekennzeichnet, daß die Atmosphäre beim Vorwärmschritt eine sich von der Gasatmosphäre beim Lötvorgang unterscheidende Atmosphäre ist.

6. Verfahren nach einem der Ansprüche 1 bis 5, dadurch gekennzeichnet, daß ein zumindest als Plasma sowohl reduzierend wie oxidierend wirkendes Prozeßgas enthaltend gleichzeitig Sauerstoff und Wasserstoff verwendet wird.

7. Verfahren nach Anspruch 6, , dadurch gekennzeichnet, daß als Prozeßgas eine Gasmischung bestehend aus
| | |
|---|---|
| 0.5 bis 10 Vol% | Sauerstoff |
| 80 bis 20 Vol% | Wasserstoff |
| 20 bis 80 Vol% | CF₄, N₂ oder Ar |
angewendet wird.

8. Verfahren nach einem der Ansprüche 1 bis 7, dadurch gekennzeichnet, daß die Plasmawirkung bzw. das Plasma aus dem Prozeßgas durch Mikrowellen, Hochfrequenzwellen und/oder eine Glimmentladung mit geeigneter Energie erzeugt wird.

9. Verfahren nach einem der Ansprüche 1 bis 8, dadurch gekennzeichnet, daß in der unmittelbaren Umgebung des Lötvorgangs, also bei der Lötstelle, Plasma erzeugt wird.

10. Verfahren nach Anspruch 9, dadurch gekennzeichnet, daß ein Lotbad (48) als Kathode einer Glimmentladung geschaltet wird.

11. Verfahren nach einem der Ansprüche 1 bis 8, dadurch gekennzeichnet, daß das Plasma außerhalb der Lötanlage erzeugt und dann, gegebenenfalls aufgeteilt, der Lötanlage zugeführt wird.

12. Verfahren nach einem der Ansprüche 1 bis 11, dadurch gekennzeichnet, daß das Prozeßgas vor Ort gemischt wird.

13. Verfahren nach einem der Ansprüche 1 bis 11, dadurch gekennzeichnet, daß das Prozeßgas als Fertiggemisch bereitgestellt wird.

14. Verfahren nach einem der Ansprüche 1 bis 13, dadurch gekennzeichnet, daß die Vorwärmung über Infrarotlicht, Mikrowellen oder andere, geeignete elektromagnetische Wellen bewirkt wird.

15. Verfahren nach einem der Ansprüche 1 bis 13, dadurch gekennzeichnet, daß die Vorwärmung durch Energieeintrag über das Plasma bewirkt wird.

16. Durchlauf-Wellenlötanlage mit Lötstation (4) und weiteren Stationen, nämlich einer Vorwärmstation (28) sowie einer Abkühloder Auslaufzone (5),
dadurch gekennzeichnet, daß eine die Lötstation (4) und die weiteren Stationen umfassende, gegen die Umgebung gasdichte Anlagenkammer (6) vorhanden ist,
daß Mittel (18) vorgesehen sind, um in dieser Kammer einen Niederdruck zu erzeugen,
und daß Einrichtungen (49,34) gegeben sind, um dort, wo die Lotwellen (40,42) erzeugt werden, eine Niederdruck-Atmosphäre im Plasmazustand auszubilden.

17. Lötanlage nach Anspruch 16, dadurch gekennzeichnet, daß gasströmungshemmende Einbauten (78,79) zwischen einzelnen Stationen vorhanden sind.

## Claims

1. Process for soldering electronic components to printed circuit boards in accordance with a wave soldering process,
in which the printed circuit boards are transported beyond one or more solder wave or solder waves formed of liquid solder, the soldering procedure itself taking place at the solder wave or the solder waves,
and in which optionally steps may be carried out, which may precede or succeed this soldering procedure, for example a preheating step and/or a cooling step,
characterized
in that at least the soldering procedure itself is carried out under low pressure and under the plasma effect of a process gas.

2. Process according to Claim 1, characterized in that the soldering procedure is preceded or succeeded by steps which are carried out under the same low pressure as the soldering process itself.

3. Process according to Claim 1 or 2, characterized in that the work is carried out at a low pressure of less than 100 mbar, preferably between 0.5 and 20 mbar.

4. Process according to one of Claims 1 to 3, characterized in that a preheating step is carried out and, during the preheating, pretreatment of the elements to be connected by soldering is achieved by a plasma effect generated there or reaching thereinto,
the same process gas as is used to form the soldering atmosphere being used there to form the plasma atmosphere.

5. Process according to Claim 4, characterized in that the atmosphere during the preheating step is an atmosphere which differs from the gas atmosphere during the soldering procedure.

6. Process according to one of Claims 1 to 5, characterized in that use is made of a process gas which simultaneously contains oxygen and hydrogen and, at least as a plasma, has both a reducing and an oxidizing effect.

7. Process according to Claim 6, characterized in that a gas mixture comprising
| | |
|---|---|
| 0.5 to 10 vol.% | oxygen |
| 80 to 20 vol.% | hydrogen |
| 20 to 80 vol.% | CF₄, N₂ or Ar |
is used as the process gas.

8. Process according to one of Claims 1 to 7, characterized in that the plasma effect or the plasma from the process gas is generated by microwaves, highfrequency waves and/or a glow discharge with suitable energy.

9. Process according to one of Claims 1 to 8, characterized in that plasma is generated in the immediate vicinity of the soldering procedure, that is to say at the soldering location.

10. Process according to Claim 9, characterized in that a solder bath (48) is connected as the cathode of a glow discharge.

11. Process according to one of Claims 1 to 8, characterized in that the plasma is generated outside the soldering installation and then, if appropriate having been divided, is supplied to the soldering installation.

12. Process according to one of Claims 1 to 11, characterized in that the process gas is mixed on site.

13. Process according to one of Claims 1 to 11, characterized in that the process gas is provided as a prepared mixture.

14. Process according to one of Claims 1 to 13, characterized in that the preheating is effected using infrared light, microwaves or other suitable electro-magnetic waves.

15. Process according to one of Claims 1 to 13, characterized in that the preheating is effected by energy input via the plasma.

16. Through-flow wave soldering installation having a soldering station (4) and further stations, namely a preheating station (28) as well as a cooling or outflow zone (5),
characterized in that an installation chamber (6) is provided containing the soldering station (4) and the further stations, which chamber is gas-tight with respect to the surroundings,
in that means (18) are provided for generating a low pressure in this chamber,
and in that devices (49, 34) are provided for forming a low-pressure atmosphere in the plasma state wherever the solder waves (40, 42) are produced.

17. Soldering installation according to Claim 16, characterized in that gas-flow-inhibiting fittings (78, 79) are provided between individual stations.

## Revendications

1. Procédé pour braser des composants électroniques à des cartes imprimées selon un procédé de brasage à la vague, dans lequel les cartes imprimées sont transportées au-dessus d'une ou de plusieurs vagues de brasure, formées de brasure liquide, l'opération de brasage proprement dite ayant lieu au niveau de la ou des vagues de brasure, et dans lequel des étapes placées le cas échéant en amont et en aval de cette opération de brasage, par exemple une étape de préchauffage et/ou une étape de refroidissement, sont effectuées, caractérisé en ce qu'au moins l'opération de brasage proprement dite est effectuée sous faible pression et sous l'effet de plasma d'un gaz de procédé.

2. Procédé suivant la revendication 1, caractérisé en ce que des étapes, qui sont effectuées sous la même faible pression que l'opération de brasage proprement dite, sont placées en amont ou en aval de l'opération de brasage.

3. Procédé suivant la revendication 1 ou 2, caractérisé en ce qu'on travaille à une faible pression inférieure à 100 mbars, de préférence entre 0,5 et 20 mbars.

4. Procédé suivant l'une quelconque des revendications 1 à 3, caractérisé en ce qu'une étape de préchauffage est effectuée et un prétraitement des éléments à unir par brasage est obtenu, lors du préchauffage, au moyen d'un effet de plasma créé à cet endroit ou atteignant cet endroit, le même gaz de procédé que pour la formation de l'atmosphère de brasage étant utilisé à cet endroit pour la formation de l'atmosphère de brasage.

5. Procédé suivant la revendication 4, caractérisé en ce que l'atmosphère lors de l'étape de préchauffage est une atmosphère différente de l'atmosphère gazeuse lors de l'opération de brasage.

6. Procédé suivant l'une quelconque des revendications 1 à 5, caractérisé en ce qu'on utilise un gaz de procédé qui présente au moins comme plasma un effet tant réducteur qu'oxydant et qui contient simultanément de l'oxygène et de l'hydrogène.

7. Procédé suivant la revendication 6, caractérisé en ce qu'on utilise comme gaz de procédé un mélange gazeux constitué de
| | |
|---|---|
| 0,5 à 10% | en volume d'oxygène |
| 80 à 20% | en volume d'hydrogène |
| 20 à 80% | en volume de CF₄, N₂ ou Ar. |

8. Procédé suivant l'une quelconque des revendications 1 à 7, caractérisé en ce que l'effet de plasma ou le plasma issu du gaz de procédé est créé au moyen de micro-ondes, d'ondes haute fréquence et/ou d'une décharge lumineuse avec une énergie appropriée.

9. Procédé suivant l'une quelconque des revendications 1 à 8, caractérisé en ce que du plasma est créé aux environs immédiats de l'opération de brasage, c'est-à-dire au poste de brasage.

10. Procédé suivant la revendication 9, caractérisé en ce qu'un bain de brasure (48) est monté comme cathode d'une décharge lumineuse.

11. Procédé suivant l'une quelconque des revendications 1 à 8, caractérisé en ce que le plasma est créé à l'extérieur de l'installation de brasage et est alors fourni, le cas échéant sous forme répartie, à l'installation de brasage.

12. Procédé suivant l'une quelconque des revendications 1 à 11, caractérisé en ce que le gaz de procédé est mélangé sur place.

13. Procédé suivant l'une quelconque des revendications 1 à 11, caractérisé en ce que le gaz de procédé est préparé sous forme de mélange prêt.

14. Procédé suivant l'une quelconque des revendications 1 à 13, caractérisé en ce que le préchauffage est effectué au moyen de lumière infrarouge, de micro-ondes ou d'autres ondes électromagnétiques appropriées.

15. Procédé suivant l'une quelconque des revendications 1 à 13, caractérisé en ce que le préchauffage est effectué par apport d'énergie au moyen du plasma.

16. Installation de brasage à la vague en continu comportant un poste de brasage (4) et des postes supplémentaires, à savoir un poste de préchauffage (28) de même qu'une zone de refroidissement ou de sortie (5), caractérisée en ce qu'une chambre d'installation (6), étanche aux gaz par rapport au milieu environnant et comprenant le poste de brasage (4) et les postes supplémentaires, est présente, que des moyens (18) sont prévus pour engendrer dans cette chambre une faible pression, et que des dispositifs (49, 34) sont fournis pour former, à l'endroit où sont créées les vagues de brasure (40, 42), une atmosphère à faible pression dans un état de plasma.

17. Installation de brasage suivant la revendication 16, caractérisée en ce que des chicanes (78, 79) ralentissant l'écoulement gazeux sont présentes entre des postes individuels.
